Europäisches Patentamt

European Patent Office

Office européen des brevets

(19)

(11) **EP 0 738 043 A1**

(12) # DEMANDE DE BREVET EUROPEEN

(43) Date de publication:
16.10.1996 Bulletin 1996/42

(51) Int. Cl.$^6$: **H03K 19/08**, H03K 19/086, H03K 19/003, G05F 3/16

(21) Numéro de dépôt: 96200909.8

(22) Date de dépôt: 03.04.1996

(84) Etats contractants désignés:
**DE FR GB**

(30) Priorité: **12.04.1995 FR 9504400**

(71) Demandeurs:
• **PHILIPS COMPOSANTS ET SEMICONDUCTEURS**
**92150 Suresnes (FR)**
Etats contractants désignés:
**FR**

• **PHILIPS ELECTRONICS N.V.**
**5621 BA Eindhoven (NL)**
Etats contractants désignés:
**DE GB**

(72) Inventeur: **Dufour, Yves**
**75008 Paris (FR)**

(74) Mandataire: **Caron, Jean**
**Société Civile S.P.I.D.**
**156, Boulevard Haussmann**
**75008 Paris (FR)**

(54) **Circuit logique de type à émetteurs couplés, fonctionnant sous une faible tension d'alimentation**

(57) Circuit logique du type à émetteurs couplés. De manière à fonctionner sous une tension d'alimentation faible, un seul élément de batterie, par exemple, la base des transistors (Q1, Q2) formant paire différentielle, reçoit le signal d'entrée (Vi, $\overline{Vi}$) via une capacité de couplage (C1, C2) tandis qu'une polarisation, de type basse fréquence, est assurée par l'intermédiaire de transistors MOS (M1, M2) commandés par les signaux d'entrée opposés à ceux appliqués aux bases correspondantes, ces transistors MOS étant reliés à une ligne (3) à une tension (Vb) supérieure à la tension d'alimentation (V1) délivrée par un générateur (10) adapté à cette fonction.
Application aux microcircuits pour appareils portables.

FIG.1

## Description

La présente invention concerne un circuit logique à transistors bipolaires, du type à émetteurs couplés et à commutation de courant, qui comporte au moins une paire différentielle de transistors de type de conductivité déterminé, formant un étage de commutation, dont les trajets collecteur - émetteur sont alimentés respectivement entre une première et une deuxième borne d'alimentation, paire qui est formée d'un premier et un deuxième transistor dont les émetteurs sont connectés entre eux et sont reliés à la deuxième borne d'alimentation via une source de courant, et dans laquelle une base au moins reçoit un signal d'entrée à travers une capacité de couplage et est également couplée à une source de tension d'alimentation de base à travers un élément à résistance élevée.

Les circuits logiques à émetteurs couplés sont bien connus et largement utilisés du fait de leur aptitude à fonctionner à des fréquences de commutation élevées. Selon une technique connue sous le nom de "ECL", les signaux de sortie d'un étage de commutation sont normalement appliqués à l'entrée d'un autre étage de commutation après passage dans un étage tampon constitué d'un transistor émetteur suiveur, qui, en abaissant le niveau de tension continue du signal, diminue fortement l'impédance sous laquelle se présente le signal de sortie.

Dans une variante de la logique à émetteur couplés, connue sous le nom de "CML", les signaux de sortie d'un étage de commutation, qui apparaissent sur les collecteurs des transistors de la paire différentielle, peuvent être appliqués directement à l'entrée d'un autre étage de commutation, c'est-à-dire sur les bases des transistors d'une autre paire différentielle. Dans ce cas, les signaux logiques apparaissant dans le circuit présentent une valeur "haute" qui est égale à la tension d'alimentation à laquelle les collecteurs de transistor sont couplés, et une valeur "basse" dont l'écart par rapport à la valeur haute est limité à 100 ou 200 mV de manière à conserver une tension collecteur-émetteur des transistors qui soit suffisante pour éviter leur saturation.

Il est connu du document JP-A-55 64438 d'appliquer sur une base d'un transistor de la paire différentielle un signal d'entrée à travers une capacité de couplage, tandis que la même base est polarisée en courant continu au moyen d'une source de tension via une résistance de valeur élevée. Cette disposition a notamment pour but d'équilibrer le fonctionnement de la paire différentielle dans laquelle la base de l'autre transistor est couplée à la masse par une capacité.

Dans le domaine des appareils portables, en radiocommunications par exemple, on cherche à réduire toujours davantage l'encombrement et le poids. Comme ces appareils sont alimentés par des piles, des efforts sont déployés en vue d'une réduction de la consommation des circuits pour allonger la durée de vie des piles. Mais les piles elles-mêmes entrent pour une part importante dans le volume et le poids de certains appareils de sorte qu'il devient souhaitable de réduire le nombre d'éléments de batterie à utiliser : 2 éléments au lieu de 3 par exemple, ou même, 1 élément au lieu de 2 si cela est possible.

Dans ces conditions il y a lieu de concevoir de nouvelles dispositions de circuit susceptible de remplacer les dispositions classiques qui ne seraient plus fonctionnelles lorsqu'elles sont alimentées à des tensions d'alimentation inférieures à 1,3 volt.

La présente invention a pour but de proposer une solution pour réaliser des circuits du type logique à émetteurs couplés, capables de fonctionner sous une faible tension d'alimentation.

Ainsi, un circuit logique selon la presente invention est caractérisé en ce que la source de tension d'alimentation de base fournit, à partir d'une tension délivrée par une sortie d'un circuit élévateur de tension d'alimentation, une tension d'alimentation de base régulée qui est plus élevée, par rapport à la deuxième borne d'alimentation, que la tension de la première borne d'alimentation, et en ce que ledit élément à résistance élevée est un transistor à effet de champ à grille isolée, à type de conductivité de canal inverse dudit type déterminé, dont la grille reçoit l'inverse logique du signal d'entrée.

Le circuit selon l'invention utilise la tension d'alimentation, fournie par une pile par exemple, pour alimenter le trajet collecteur-émetteur des transistors de l'étage de commutation. Il suffit alors d'une tension de l'ordre de 1 Volt ou même un peu moins.

A cause de la chute de tension relativement importante dans la jonction base-émetteur des transistors, et surtout à basse température, les bases des transistors ne disposent plus d'une tension continue suffisante pour réaliser une polarisation évitant la saturation des transistors. Ainsi l'invention prévoit-elle d'utiliser un circuit élévateur de tension pour réaliser une source de tension permettant de polariser les bases des transistors à une tension plus élevée que la tension d'alimentation proprement dite. Ainsi, tant que la tension d'alimentation reste suffisante pour alimenter les collecteurs des transistors, le circuit continue à fonctionner normalement. L'utilisation d'un circuit élévateur de tension, conformément à l'invention, est facilitée par le fait que l'alimentation des bases des transistors ne consomme qu'un courant très faible comparé au courant débité par le trajet collecteur-émetteur d'un transistor dans un état conducteur.

La polarisation des bases de transistor à travers une résistance de valeur élevée imposerait une valeur élevée à la capacité de couplage d'un étage à l'autre faute de quoi l'étage de commutation ne pourrait traiter un signal à basse fréquence. Or cette solution présente l'inconvénient de l'encombrement de cette capacité à la surface d'un circuit intégré.

L'invention qui prévoit l'utilisation de transistors à effet de champ pour la polarisation des bases, permet au contraire de traiter des signaux à fréquence très basse, même lorsque la capacité de couplage est de très faible valeur, 1 ou 2 pF par exemple, et donc facilement intégrable.

Selon un mode préféré de mise en oeuvre de l'invention, le circuit logique est caractérisé, en outre, en ce que la source de tension d'alimentation de base comporte :

- un autre transistor bipolaire, dit troisième transistor
- un autre transistor à effet de champ dit quatrième transistor, troisième et quatrième transistors qui sont de construction semblable à celle des transistors d'un étage de commutation, et où le drain du quatrième transistor est connecté à la base du troisième transistor,
- et une autre source de courant qui est disposée entre la sortie du circuit élévateur de tension et la source du quatrième transistor, source de courant à laquelle est connecté le collecteur du troisième transistor en un noeud constituant une sortie de ladite source de tension d'alimentation de base, tandis qu'à la grille du quatrième transistor est appliquée une tension comprise dans l'intervalle de variation du signal d'entrée et qu'une tension continue est imposée à l'émetteur du troisième transistor.

De cette manière, la source de tension d'alimentation de base produit une tension dont les caractéristiques sont bien adaptées à son utilisation dans l'étage de commutation.

Dans une réalisation avantageuse de l'invention, la tension appliquée à la grille du quatrième transistor est pratiquement égale à la valeur médiane du signal d'entrée et la valeur du courant fourni par l'autre source de courant est égale à la moitié du courant qui alimente les émetteurs couplés de l'étage de commutation.

La source de tension d'alimentation de base se trouve alors réglée pour que dans l'étage de commutation, lorsque la paire différentielle de transistors est placée à son seuil de basculement, la tension des émetteurs réunis soit égale à la tension imposée à l'émetteur du troisième transistor, de la source de tension d'alimentation de base.

Comme on le verra plus en détail par la suite, le réglage ainsi réalisé reste approprié lorsque la température varie, du fait que les transistors utilisés, qu'ils soient dans l'étage de commutation ou dans la source de tension d'alimentation de base, peuvent être construits pour présenter des caractéristiques électriques très voisines.

Pour conserver une tension collecteur-émetteur des transistors de l'étage de commutation sensiblement constante lorsque la tension d'alimentation du circuit varie, l'invention prévoit avantageusement que, dans la source de tension d'alimentation de base, la tension continue imposée à l'émetteur du troisième transistor soit fournie par des moyens décaleurs de tension connectés par ailleurs à la première borne d'alimentation.

Bien entendu, l'invention n'est pas limitée au cas d'une seule paire différentielle de transistors couplée à une source de tension d'alimentation de base mais au contraire prévoit qu'une pluralité de paires différentielles puisse être associée à une même source de tension d'alimentation de base.

Par ailleurs l'invention s'applique également au cas où deux paires différentielles de transistors sont agencées en série entre la première et la deuxième borne d'alimentation.

Plus précisément, selon une variante de mise en oeuvre de l'invention, le circuit logique est caractérisé en ce que dans l'étage de commutation, les émetteurs couplés de la paire différentielle de transistors sont alimentés par la source de courant à travers le trajet collecteur - émetteur d'un transistor d'une autre paire différentielle de transistors dont les bases sont commandées par couplage direct d'un signal de sortie d'un autre étage, décalé en tension.

La description qui va suivre en regard des dessins annexés donnés à titre d'exemples non limitatifs, fera bien comprendre en quoi consiste l'invention et comment elle peut être réalisée.

La figure 1 représente le schéma d'un circuit logique conforme à l'invention,
la figure 2 donne le schéma électrique d'une porte OU (ou NON-OU) utilisant un circuit selon l'invention,
la figure 3 est un schéma électrique de principe d'une source de tension d'alimentation de base et la figure 4, celui d'un exemple de réalisation d'une telle source de tension, et
la figure 5 donne le schéma d'un autre mode de mise en oeuvre de l'invention.

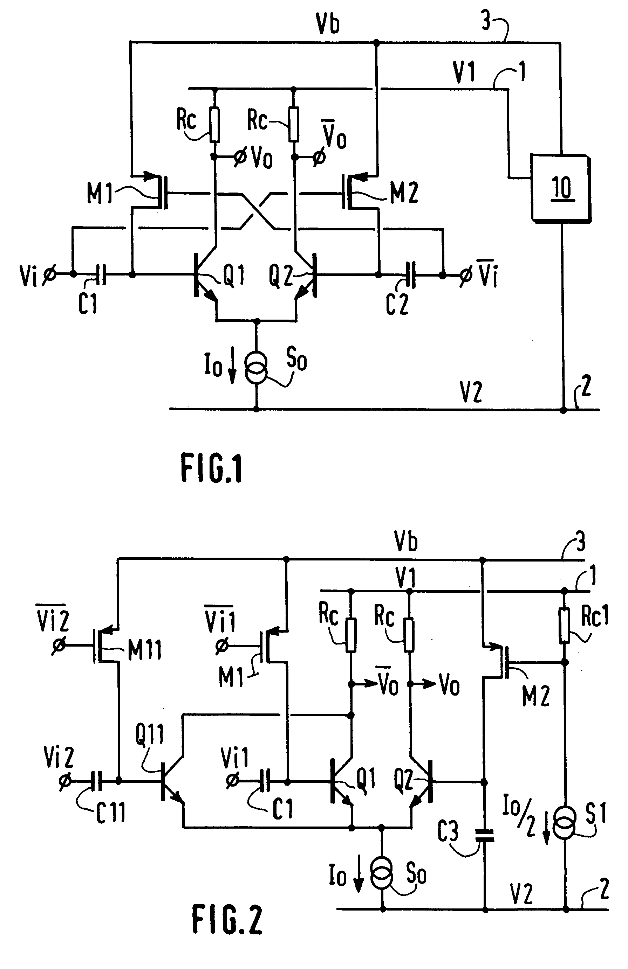

En se reportant à la figure 1, le circuit selon l'invention comporte une paire différentielle de transistors respectivement Q1, Q2, de type NPN qui forment un étage de commutation et dont les trajets collecteur-émetteur sont alimentés entre une première borne d'alimentation 1 portant une tension positive V1 et une deuxième borne d'alimentation 2 portée à une tension V2 qui, dans l'exemple, est une tension de référence. Les transistors Q1 et Q2 ont leurs émetteurs connectés entre eux. Ils sont reliés à la borne d'alimentation 2 via une source de courant So qui débite un courant lo. Les collecteurs des transistors Q1 et Q2 sont reliés à la borne d'alimentation 1 via deux résistances de charge de valeur égale notées Rc sur la figure. La base du transistor Q1 reçoit un signal d'entrée Vi à travers une capacité de couplage C1, et la base du transistor Q2 reçoit l'inverse logique du signal d'entrée Vi à travers une capacité de couplage C2. Le collecteur du transistor Q2 fournit un signal de sortie Vo et le collecteur du transistor Q1 fournit l'inverse logique du signal Vo qui est également l'inverse logique du signal d'entrée Vi.

Du point de vue de la polarisation des transistors Q1 et Q2 en basse fréquence ou en courant continu, les bases sont alimentées à partir d'une source de tension d'alimentation de base 10 qui fournit en sortie une tension Vb qui est plus élevée que la tension V1 de la borne d'alimentation 1. Cette source 10 inclut un circuit élévateur de tension qui produit sur une ligne 3 à partir de la tension d'alimentation V1, une tension Vb plus élevée. La base du transistor Q1 est reliée à la ligne 3 portant la tension d'alimentation de base Vb via un transistor à effet de champ M1 de type MOS dont la grille reçoit l'inverse logique du signal d'entrée Vi. De manière symétrique, la base du transistor Q2 est reliée à la ligne 3 via un transistor M2 de même type que le transistor M1, et dont la grille reçoit le signal logique d'entrée Vi. Comme il sera expliqué plus en détail par la suite, la source de tension d'alimentation de base 10 est constituée de telle manière que les signaux d'entrée Vi et son inverse logique $\overline{Vi}$ qui sont appliqués aux grilles des transistors M2 et M1 sont des signaux tels que ceux provenant de la sortie d'un autre étage de commutation, similaire à celui qui est représenté sur la figure. En d'autres termes, les signaux de sortie Vo, $\overline{Vo}$ présentent les mêmes niveaux de tension que les signaux d'entrée Vi et $\overline{Vi}$.

Ainsi constitué, l'étage de commutation représenté est susceptible de commuter des signaux présentant une fréquence très élevée du fait que les signaux d'entrée sont appliqués à travers des capacités de couplage C1, C2. Cependant, l'étage peut également conserver une forme de signaux de sortie convenable lorsque la fréquence des signaux d'entrée est basse du fait qu'une polarisation de type courant continu est appliquée par les transistors à effet de champ M1 et M2.

Le schéma de principe de la figure 1 est celui d'un amplificateur ou d'un inverseur selon l'utilisation qui est faite des signaux de sortie Vo et $\overline{Vo}$.

A la figure 2 est représenté le schéma électrique d'une porte OU - ou NON-OU - selon l'utilisation des signaux de sortie. Les éléments ayant mêmes fonctions qu'à la figure 1 sont représentés avec les mêmes signes de référence. Le circuit de la figure 2 comporte une paire différentielle de transistors NPN Q1, Q2 dont les émetteurs réunis sont alimentés par un courant Io fourni par une source de courant So.

Par rapport au circuit de la figure 1, ce circuit présente ici un transistor Q2 qui reçoit via le transistor M2, une polarisation fixe, équivalente à la médiane du signal d'entrée logique. Cette polarisation est réalisée au moyen d'une résistance RC1 connectée d'une part à la borne d'alimentation 1 et d'autre part, à une source de courant S1 qui débite un courant Io/2 vers la deuxième borne d'alimentation 2.

La résistance RC1 présente donc par rapport à la borne d'alimentation 1 une chute de tension qui est égale à la moitié de l'écart de tension présent dans le signal de sortie. Le transistor à effet de champ M2, connecté entre la ligne 3 présentant la tension d'alimentation de base Vb et la base du transistor Q2, a sa grille qui est connectée au noeud reliant la résistance RC1 à la source de courant S1.

A la base du transistor Q1 est appliqué un signal d'entrée Vi1 d'une manière identique à l'agencement correspondant de la figure 1 pour l'application du signal d'entrée Vi. De même, un transistor à effet de champ M1 contrôle la polarisation de la base du transistor Q1 sous l'effet de la commande de l'inverse logique du signal Vi1. Pour former une fonction OU à deux entrées, un transistor NPN additionnel Q11 a son trajet collecteur/émetteur connecté en parallèle avec celui du transistor Q1 et sa base qui reçoit un autre signal d'entrée Vi2. Le collecteur du transistor Q11 est relié au collecteur du transistor Q1, où il partage la même résistance de charge laquelle fournit un signal de sortie $\overline{Vo}$. La base du transistor Q11 reçoit un autre signal d'entrée Vi2 à travers une capacité de couplage C11. Elle est d'autre part polarisée à l'aide d'un transistor à effet de champ MOS M11 dont la source est connectée à la ligne 3 portant la tension d'alimentation de base Vb, et dont la grille reçoit l'inverse logique dudit autre signal d'entrée Vi2. Lorsque les deux signaux d'entrée Vi1 et Vi2 sont à l'état bas, le courant de la source So circule en majorité dans le transistor Q2, tandis que lorsque l'une au moins des entrées portant les signaux Vi1 ou Vi2 est à l'état haut, le courant de la source So circule principalement dans la résistance de charge commune aux transistors Q1 et Q11.

Le circuit de la figure 2, constitue donc une fonction OU ou NON-OU selon la manière avec laquelle sont utilisés les signaux de sortie Vo et $\overline{Vo}$ à la suite de cet étage. On sait que la plupart des fonctions logiques peuvent être réalisées à partir d'une association de portes NON-OU de sorte que le schéma de la figure 2 est un exemple typique de circuit logique appliquant les techniques de l'invention.

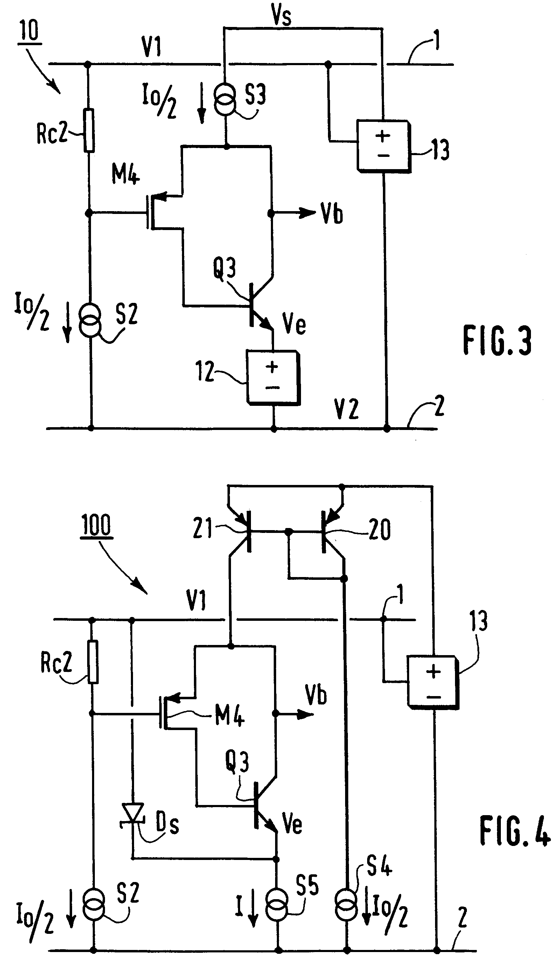

La figure 3 représente le schéma de principe d'une source de tension telle que représentée en 10 sur la figure 1.

La source de tension d'alimentation de base de la figure 3 fournit en sortie une tension Vb, qui comme on l'a vu précédemment est plus élevée que la tension V1 de la borne d'alimentation 1. Cette source d'alimentation comporte en conséquence un circuit multiplicateur de tension 13 qui fournit - à partir de l'énergie de la borne d'alimentation 1 - une tension de sortie Vs dont la valeur est plus élevée que V1. En utilisant un circuit doubleur de tension bien connu dans la technique et dont la description n'est pas nécessaire ici, on obtient une tension Vs un peu inférieure au double de la tension V1, compte tenu du rendement propre à ce genre de circuit. Une telle tension est normalement suffisante pour les besoins de l'invention.

La source de tension 10 comporte un transistor NPN Q3 et un transistor à effet de champ de type MOS M4, à canal P. Le drain du transistor M4 est connecté à la base du transistor Q3 et l'émetteur de ce dernier transistor est assujetti à une tension Ve réalisée au moyen d'un générateur de tension 12. Cette tension peut être fixée à quelques dixièmes de volts au-dessus de la tension V2 de la deuxième borne d'alimentation 2, par exemple au moyen d'un diode Schottky. A la grille du transistor M4, est appliquée une tension correspondant à la médiane du signal d'entrée ce qui est réalisé par une chute de tension dans une résistance Rc2 connectée à la tension d'alimentation V1 et parcourue par un courant lo/2, débité par une source de courant S2. Cette valeur de courant correspond à la moitié du courant nominal alimentant les paires de transistors dans un étage de commutation. La grille du transistor M4 est donc ainsi portée à une tension qui correspond à celle d'une sortie d'un étage de commutation placé au seuil de basculement. La source du transistor M4 est alimentée à partir de la tension Vs via une source de courant S3 qui débite un courant lo/2. Enfin, le collecteur du transistor Q3 est connecté à la source du transistor M4 ainsi qu'à la source de courant S3 en un noeud qui forme la sortie de la source de tension d'alimentation de base, fournissant la tension Vb.

Le fonctionnement du circuit de la figure 3 va maintenant être expliqué brièvement. On considère tout d'abord que la tension Vb qui alimente le courant de base des étages de commutation n'a à fournir qu'un courant faible qui peut être négligé. En négligeant encore le courant de base du transistor Q3, on peut considérer que ce transistor est placé dans des conditions comparables au seuil de basculement d'un des transistors d'un étage de commutation. En effet, la grille du transistor M4 reçoit une tension correspondant à la médiane du signal d'entrée et sa source présente une tension Vb telle que le transistor Q3 soit placé dans des conditions voulues pour débiter un courant lo/2. Le montage est doté d'une forte contre-réaction de sorte que la tension Vb est peu influencée par des fluctuations provenant du circuit.

Si on tient compte maintenant du faible courant traversant le trajet source/drain du transistor M4, ainsi qu'un courant modeste débité par la source de tension d'alimentation de base, le courant débité par le transistor Q3 n'est que peu affecté. Il se produit une répercussion très faible sur la tension émetteur/base du transistor Q3, qui varie de manière logarithmique, ainsi qu'une très faible vairation de la tension grille/source du transistor M4. En effet, celui-ci se trouve placé dans des conditions de conduction inférieures au seuil, dans une région où il présente une très forte transconductance. Un tel agencement des transistors M4, Q3 et de la source de tension 12, constitue donc une reproduction de l'état d'un transistor d'un étage de commutation, lorsque le transistor est au seuil de basculement de cet étage. Il est clair que des signaux d'entrée dont les niveaux haut et bas sont répartis de part et d'autre du niveau de tension imposé à la grille du transistor M4, produiront dans l'étage de commutation un déséquilibre de la paire différentielle, entraînant la commutation de l'étage.

La figure 4, représente le schéma d'une variante de réalisation de la source de tension d'alimentation de base. Une telle source 100 comporte un circuit doubleur de tension 13, fournissant une tension Vs à partir de la tension V1 de la première borne d'alimentation, d'une manière similaire au circuit de la figure 3.

Comme dans le circuit de la figure 3, la source de tension de base comporte un transistor à effet de champ M4, dont le drain est connecté à la base d'un transistor NPN Q3. Une source de courant S4 débite un courant de valeur lo/2 dans une branche d'entrée d'un miroir de courant à transistors PNP 20, 21. Les émetteurs des transistors 20 et 21 sont connectés à la sortie du circuit doubleur de tension 13 et donc portés à la tension Vs. Le transistor 21, qui constitue la branche de sortie du miroir de courant a son collecteur connecté à la source du transistor M4 et au collecteur du transistor Q3. Un tel montage réalise une source de courant, fournissant un courant lo/2 qui est équivalent à la source de courant S3 représentée à la figure 3.

La grille du transistor à effet de champ M4 est polarisée de la même manière que dans le montage de la figure 3, c'est-à-dire par une chute de tension dans une résistance de charge Rc2 connectée d'une part à la tension V1 de la première borne d'alimentation, et d'autre part à une source de courant S2 débitant un courant lo/2.

A la différence du montage de la figure 3, la tension d'émetteur Ve à laquelle l'émetteur du transistor Q3 est assujetti est liée à la tension d'alimentation V1 par un décalage de tension constant réalisé au moyen d'une diode Schottky Ds. L'anode de cette diode est connectée à la tension V1 de la borne 1 d'alimentation. Sa cathode est connectée à l'émetteur du transistor Q3 en un noeud relié à une source de courant S5 qui débite un courant I vers la deuxième borne d'alimentation 2. La valeur du courant I peut être quelconque à condition qu'elle soit supérieure à lo/2 et peut être choisie pour procurer la chute de tension recherchée dans la diode Ds. En effet, en l'absence de consommation sur la tension de sortie Vb, le courant traversant la diode Ds est égal à I - lo/2 .

Selon ce mode de mise en oeuvre la tension Ve à laquelle se trouve placé l'émetteur du transistor Q3 (ainsi que l'émetteur des transistors dans l'étage de commutation), suit les écarts de la tension d' alimentation V1, d'une manière parallèle, qui assure aux transistors bipolaires une tension émetteur/collecteur fixée par la chute de tension dans la diode Ds. En choisissant la surface de jonction de la diode Ds ainsi que le courant qui la parcourt, on peut modifier dans une certaine mesure la valeur de la tension émetteur/collecteur minimale qui sera assurée dans tous les transistors bipolaires compte tenu de l'écart de tension choisi pour le signal de sortie, 200mV par exemple.

En examinant les valeurs rencontrées en pratique, pour les tensions émetteur/base et collecteur/émetteur des transistors NPN du circuit conforme à l'invention, on constate que la tension minimale émetteur/collecteur qui permet d'éviter la saturation est environ égale à la moitié de la tension émetteur/base du même transistor. Comme les tensions de polarisation de base sont obtenues par ailleurs au moyen d'un circuit multiplicateur de tension, on comprend que la tension d'alimentation V1 - V2 du circuit conforme à l'invention peut être nettement inférieure à la tension utilisée dans l'art antérieur.

A titre d'exemple pratique, les circuits des figures 1 ou 2 peuvent être alimentés par une tension d'alimentation V1 - V2 de l'ordre de 0,9 Volt, le circuit doubleur de tension fournissant une tension Vs de l'ordre de 1,6 Volt, et la source de tension d'alimentation de base fournissant une tension Vb voisine de 1,1 Volt.

Selon le mode de réalisation décrit à la figure 4, la tension d'alimentation de base Vb est telle que les transistors bipolaires ont leur émetteur qui présente une tension Ve en relation avec la tension d'alimentation V1, et qui présente avec cette dernière un écart minimal à respecter pour le fonctionnement du circuit. Ainsi quand la tension d'alimentation V1 est relativement élevée, la tension d'émetteur Ve l'est également de sorte qu'il est également possible d'insérer un autre étage de commutation dans l'intervalle de tension représenté par Ve - V2.

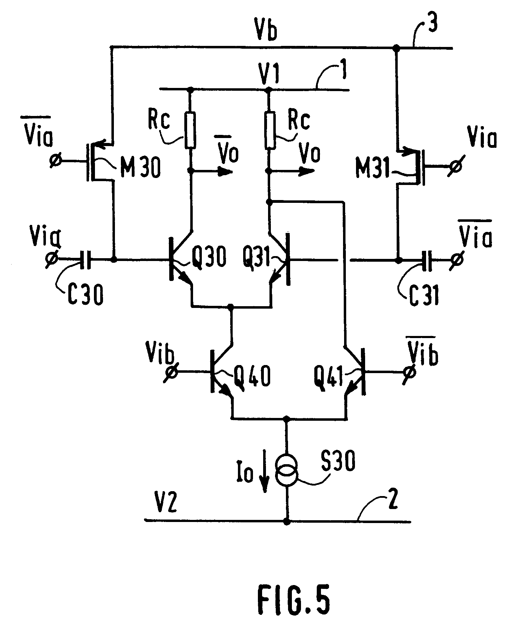

La figure 5 représente un tel mode de mise en oeuvre de l'invention. Une paire différentielle de transistors Q30, Q31, forme un étage de commutation comparable à celui de la figure 1, dans lequel les collecteurs des transistors sont couplés à la première borne d'alimentation 1 via des résistances de charge de collecteur Rc. Les transistors Q30 et Q31, reçoivent par ailleurs un premier signal d'entrée sur leur bases. Plus précisément, un signal Via est appliqué à la base du transistor Q30 à travers une capacité de couplage C30, et un signal $\overline{Via}$ est appliqué à la base du transistor Q31 à travers une capacité de couplage C31.

La base du transistor Q30 est par ailleurs polarisée à partir d'une tension d'alimentation de base Vb fournie par la ligne 3 via un transistor à effet de champ MOS M30 dont la grille reçoit l'inverse logique du signal d'entrée Via. D'une manière symétrique, la base du transistor Q31 est polarisée à partir de la tension d'alimentation de base Vb via un transistor à effet de champ MOS M31 dont la grille reçoit le signal d'entrée Via.

Avec une tension d'alimentation V1 égale ou supérieure à 1,2 Volt environ, il est possible d'insérer un autre étage de commutation entre la paire de transistors Q30, Q31 et la deuxième borne d'alimentation 2. Ainsi, les émetteurs réunis des transistors Q30 et Q31 sont-ils alimentés par une source de courant S30 débitant le courant nominal Io vers la deuxième borne d'alimentation 2 à travers le trajet collecteur/émetteur d'un transistor Q40. Celui-ci constitue avec un autre transistor Q41 une autre paire différentielle de transistors commandées par un deuxième signal d'entrée Vib et son inverse logique $\overline{Vib}$. En observant les tensions pratiques mises en oeuvre dans ce circuit, on constate que la commande des bases des transistors Q40 et Q41 peut être réalisée sans avoir recours à une alimentation spéciale, la paire différentielle Q40 et Q41 étant placée dans un intervalle de tension suffisamment bas par rapport à l'intervalle de tension V1 - V2. La commande des bases de ces transistors peut donc être faite par liaison directe avec les sorties d'un autre étage de commutation sans utiliser de capacité de couplage. En effet on constate en pratique que les niveaux de tensions tels que Vo et $\overline{Vo}$ sont compatibles avec les tensions des bases des transistors Q40 et Q41.

L'avantage de ce mode de mise en oeuvre de l'invention réside dans le fait de pouvoir faire fonctionner deux étages de commutation en série avec une tension d'alimentation V1 - V2 qui était utilisable seulement pour un étage dans les circuits de l'art antérieur.

Le circuit représenté à la figure 5 qui correspond à une porte ET ou NON-ET selon l'utilisation ultérieure des signaux de sortie Vo et $\overline{Vo}$, peut donc fonctionner en utilisant une tension d'alimentation fournie par un seul élément de batterie.

**Revendications**

1. Circuit logique à transistors bipolaires, du type à émetteurs couplés et à commutation de courant, qui comporte au moins une paire différentielle de transistors de type de conductivité déterminé, formant un étage de commutation, dont les trajets collecteur - émetteur sont alimentés respectivement entre une première et une deuxième borne d'alimentation, paire qui est formée d'un premier et un deuxième transistor dont les émetteurs sont connectés entre eux et sont reliés à la deuxième borne d'alimentation via une source de courant, et dans laquelle une base au moins reçoit un signal d'entrée à travers une capacité de couplage et est également couplée à une source de tension d'alimentation de base à travers un élément à résistance élevée,
   caractérisé en ce que la source de tension d'alimentation de base fournit, à partir d'une tension délivrée par une sortie d'un circuit élévateur de tension d'alimentation, une tension d'alimentation de base régulée qui est plus élevée, par rapport à la deuxième borne d'alimentation, que la tension de la première borne d'alimentation, et en ce que ledit élément à résistance élevée est un transistor à effet de champ à grille isolée, à type de conductivité de canal inverse dudit type déterminé, dont la grille reçoit l'inverse logique du signal d'entrée.

2. Circuit logique selon la revendication 1, caractérisé en ce que la source de tension d'alimentation de base comporte :

   - un autre transistor bipolaire dit troisième transistor
   - un autre transistor à effet de champ dit quatrième transistor, troisième et quatrième transistors qui sont de construction semblable à celle des transistors d'un étage de commutation, et où le drain du quatrième transistor est connecté à la base du troisième transistor,

- et une autre source de courant qui est disposée entre la sortie du circuit élévateur de tension et la source du quatrième transistor, source de courant à laquelle est connecté le collecteur du troisième transistor en un noeud constituant une sortie de ladite source de tension d'alimentation de base, tandis qu'à la grille du quatrième transistor est appliquée une tension comprise dans l'intervalle de variation du signal d'entrée et qu'une tension continue est imposée à l'émetteur du troisième transistor.

3. Circuit logique selon la revendication 2, caractérisé en ce que la tension appliquée à la grille du quatrième transistor est pratiquement égale à la valeur médiane du signal d'entrée et la valeur du courant fourni par l'autre source de courant est égale à la moitié du courant qui alimente les émetteurs couplés de l'étage de commutation.

4. Circuit logique selon la revendication 2, caractérisé en ce que dans la source de tension d'alimentation de base, la tension continue imposée à l'émetteur du troisième transistor est fournie par des moyens décaleurs de tension connectés par ailleurs à la première borne d'alimentation.

5. Circuit logique selon la revendication 2, caractérisé en ce dans l'étage de commutation, les émetteurs couplés de la paire différentielle de transistors sont alimentés par la source de courant à travers le trajet collecteur - émetteur d'un transistor d'une autre paire différentielle de transistors dont les bases sont commandées par couplage direct d'un signal de sortie d'un autre étage, décalé en tension.

FIG.1

FIG.2

FIG.3

FIG.4

FIG.5

# EP 0 738 043 A1

**Office européen des brevets**  RAPPORT DE RECHERCHE EUROPEENNE

Numero de la demande

EP 96 20 0909

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| D,A | PATENT ABSTRACTS OF JAPAN vol. 4, no. 104 (E-019), 25 Juillet 1980 & JP-A-55 064438 (NEC CORP), 15 Mai 1980, * abrégé * | 1 | H03K19/08 H03K19/086 H03K19/003 G05F3/16 |
| A | PATENT ABSTRACTS OF JAPAN vol. 12, no. 259 (P-733), 21 Juillet 1988 & JP-A-63 046691 (TOSHIBA CORP), 27 Février 1988, * abrégé * | 1 | |

**DOMAINES TECHNIQUES RECHERCHES (Int.Cl.6)**

H03K

Le présent rapport a été établi pour toutes les revendications

| Lieu de la recherche | Date d'achèvement de la recherche | Examinateur |
|---|---|---|
| BERLIN | 12 Juillet 1996 | Taylor, P |

**CATEGORIE DES DOCUMENTS CITES**

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)